(19) Europäisches Patentamt
European Patent Office
Office européen des brevets

(11) **EP 1 956 384 B1**

(12) **EUROPÄISCHE PATENTSCHRIFT**

(45) Veröffentlichungstag und Bekanntmachung des Hinweises auf die Patenterteilung:
**12.03.2014 Patentblatt 2014/11**

(51) Int Cl.:
*G01R 35/00* (2006.01)     *G01R 15/18* (2006.01)
*G01R 15/20* (2006.01)

(21) Anmeldenummer: **08001107.5**

(22) Anmeldetag: **22.01.2008**

(54) **Stromsensoranordnung**

Current sensor device

Dispositif capteur de courant

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **08.02.2007 DE 102007006219**

(43) Veröffentlichungstag der Anmeldung:
**13.08.2008 Patentblatt 2008/33**

(73) Patentinhaber: **Vacuumschmelze GmbH & Co. KG 63450 Hanau (DE)**

(72) Erfinder: **Lenhard, Friedrich 63452 Hanau (DE)**

(74) Vertreter: **Schmuckermaier, Bernhard Westphal, Mussgnug & Partner Patentanwälte Herzog-Wilhelm-Strasse 26 80331 München (DE)**

(56) Entgegenhaltungen:
**US-A- 5 654 630**

• **Texas Instruments: "Sensor Signal Conditioning IC for Closed-Loop Magnetic Current Sensor", , Oktober 2006 (2006-10), Seiten 1-33, XP002687347, Gefunden im Internet: URL:http://www.datasheetdir.com/DRV401+dow nload [gefunden am 2012-11-14]**

**Beschreibung**

Die Erfindung betrifft eine Stromsensoranordnung.

Stromsensoren weisen üblicherweise ein magnetisches Modul und ein Elektronikmodul auf. Das magnetische Modul umfasst dabei beispielsweise einen oder keinen Luftspalt aufweisenden Ringkern, durch den ein Leiter (Primärleiter) für den zu messenden Strom geführt ist und der mit mindestens einer Wicklung versehen sein kann. Diese Wicklung kann als stromgespeiste Kompensationswicklung oder als stromliefernde Sensorwicklung dienen, je nach Anwendungsfall. Daneben können auch spezielle Magnetfeldsonden wie zum Beispiel induktive Magnetfeldsonden oder Hall-Sonden zusätzlich oder alternativ zum Einsatz kommen. Das Elektronikmodul weist die Auswerteschaltung, die Ansteuerschaltung oder beides auf, je nach Anwendungsfall. Bei den Anwendungsfällen unterscheidet man hauptsächlich zwischen direkt abbildenden Stromsensoren und Stromsensoren nach dem Kompensationsprinzip. Beide setzen Magnetfeldsonden ein, die im Luftspalt des Ringkerns oder im Ringkern selbst die Stärke des magnetischen Flusses messen, der durch das Magnetfeld des Primärleiters im Ringkern induziert wird.

Die Elektronikmodule sind insbesondere bei Anwendungen im Automobil zum Schutz vor Feuchtigkeit, Schmutz und mechanischer Beschädigung meist als hermetisch dichte Module wie beispielsweise vergossene oder verkapselte Baugruppen oder integrierte Schaltkreise ausgeführt, können aber auch nur elektronische Bauteile aufweisende Träger sein. Darüber hinaus können Elektronikmodul und magnetisches Modul einstückig ausgeführt werden, also beispielsweise miteinander vergossen sein.

Derartige Stromsensoren sind beispielsweise aus Texas Instruments: "Sensor Signal Conditioning IC for Closed-Loop Magnetic Current Sensor", Oktober 2006 und US 5 654 630 A bekannt.

Wenn Stromsensoren in sicherheitsrelevanten Anwendungen eingesetzt werden, muss unter anderem sichergestellt werden, dass der Stromsensor die gewünschte Funktion ordnungsgemäß ausübt, da andernfalls eine unerwünschte Schädigung oder gar Zerstörung des Sensors und seiner Umgebung eintreten kann.

Eine solche Schädigung oder Zerstörung kann zum Beispiel dann auftreten, wenn auf Grund von beispielsweise fehlerhafter Ansteuerung, einem Kurzschluss oder einer Verpolung ein überhöhter oder falsch gepolter Strom durch eine durch den Stromsensor zu überwachende Anordnung fließt und ein solcher unerwünschter Strom von einem zu dessen Überwachung vorgesehenen Stromsensor nicht ordnungsgemäß erkannt wird. Daher ist es bei solchen Anwendungen notwendig, Fehlerzustände zu erkennen und diese nach außen zu signalisieren.

Andererseits sollen Stromsensoranordnungen insbesondere bei Anwendungen im Automobil mit einer möglichst geringen Anzahl von Leitungen auskommen, da jeder mit einer übergeordneten oder nachgeschalteten Anordnung zu verdrahtende Anschluss zusätzlichen Verdrahtungsaufwand und dadurch Kosten erzeugt sowie die Komplexität und damit die Störanfälligkeit erhöht.

Aufgabe der Erfindung ist es daher, einen Stromsensor bereitzustellen, bei dem die oben genannten Nachteile nicht auftreten.

Die Aufgabe wird gelöst durch einen Stromsensor gemäß Anspruch 1. Ausgestaltungen und Weiterbildungen des Erfindungsgedankens sind Gegenstand von Unteransprüchen.

Es wird insbesondere eine Stromsensoranordnung beschrieben mit einem magnetischen Modul zur Erzeugung eines zu einem ihm zugeführten, zu messenden Strom proportionales, potentialfreies Signal erzeugt und mit einem mit dem magnetischen Modul elektrisch gekoppelten Elektronikmodul zur Auswertung des potentialfreien Signals vom magnetischen Modul und Erzeugen eines zum messenden Strom proportionalen analogen Ausgangsspannung aus dem potentialfreien Signal, wobei das Elektronikmodul einen Referenzspannungseingang zur Einprägung einer Referenzspannung von außen oder einen Referenzspannungsausgang zum Herausführen der Referenzspannung nach außen oder beides, Referenzspannungseingang und Referenzspannungsausgang, aufweisen kann, das Elektronikmodul bei Auftreten mindestens einer Fehlfunktion mindestens ein Fehlersignal erzeugt und das mindestens eine Fehlersignal der Referenzspannung am Referenzspannungseingang oder Referenzspannungsausgang oder an beiden überlagert wird.

Die Erfindung wird nachfolgend anhand der in den Figuren der Zeichnung dargestellten Ausführungsbeispiele näher erläutert, wobei gleiche Elemente mit gleichen Bezugszeichen versehen sind. Es zeigt:

Figur 1    den Aufbau eines Stromsensors nach dem Kompensationsprinzip;

Figur 2    einen Stromsensor nach Figur 1 mit zusätzlicher Testwicklung;

Figur 3    einen Stromsensor nach Figur 1 mit zusätzlicher Fehlerdetektion;

Figur 4    einen Kompensationsstromsensor, bei dem ein Fehlersignal einer an einem Ausgang anliegenden Messspannung überlagert ist;

Figur 5    einen Kompensationsstromsensor, bei dem ein Fehlersignal einer Referenzspannung überlagert ist;

Figur 6    einen Kompensationsstromsensor, bei dem ein Fehlersignal und ein Übersteuerungssignal einer Referenzspannung überlagert sind;

Figur 7    einen Kompensationsstromsensor, bei dem ein Fehlersignal und ein Übersteuerungssignal einer Referenzspannung auf eine zu Figur 6 alternative Weise überlagert sind; und

Figur 8    eine beispielhafte Beschaltung einer Open-Collector-Ausgangsstufe zur Überlagerung des Fehlersignals bzw. des Übersteuerungssignals.

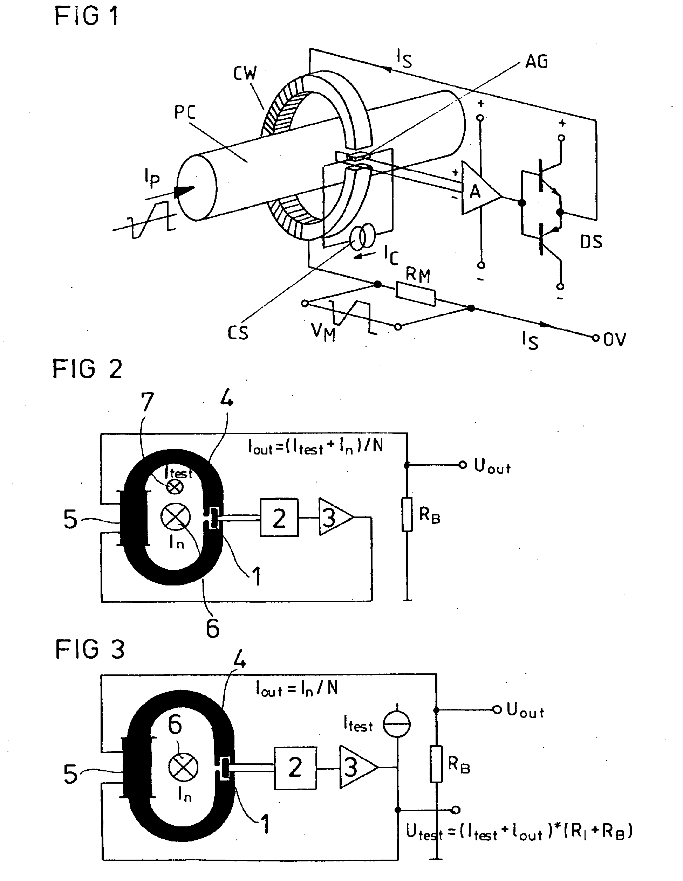

Eine beispielhafte Stromsensoranordnung nach dem Kompensationsprinzip ist in Figur 1 dargestellt. Eine solche Stromsensoranordnung weist ein magnetisches Modul auf, das vorliegend durch einen Primärleiter PC, einen den Primärleiter PC umfassenden Ringkern RC mit Luftspalt AG, eine um den Ringkern RC gewickelte Kompensationswicklung CW und einen in diesem Luftspalt angeordneten Hall-Sensor HS gebildet wird. Der Primärleiter PC wird dabei durch einen zu messenden beziehungsweise zu überwachenden Primärstrom $I_p$ durchflossenen.

Das zugehörige Elektronikmodul weist eine Stromquelle CS zur Einspeisung eines Stroms $I_C$ in den Hall-Sensor HS, eine Verstärkeranordnung A zur Verstärkung der Hall-Spannung $V_H$ des Hall-Sensors HS und eine der Verstärkeranordnung A nachgeschaltete Treiberstufe DS zur Erzeugung eines Sekundärstroms $I_S$ für die Kompensationswicklung CW auf. In Reihe zur Kompensationswicklung CW ist ein Widerstand $R_M$ geschaltet, über dem eine zum Sekundärstrom $I_S$ proportionale Messspannung $V_M$ abfällt. Da sich der Sekundärstrom $I_S$ aber proportional zum Primärstrom $I_p$ verhält, ist die Messspannung $V_M$ ein Maß für den Primärstrom $I_p$.

Während die direkt abbildenden Stromsensoren als Ausgangsspannung $V_{OUT}$ beispielsweise die verstärkte Hallspannung $V_H$ liefern, wird bei Stromsensoren nach dem Kompensationsprinzip der zu $V_H$ proportionale Sekundärstrom $I_S$ über eine Kompensationswicklung auf dem Ringkern als Gegenkopplungssignal auf den Ringkern zurückgeführt, um die Primärflussdichte $B_p$ durch eine Sekundärflussdichte $B_S$ auszugleichen.

Der Sekundärstrom $I_S$ ist um das Übersetzungsverhältnis zwischen dem Primärleiter und der Kompensationswicklung kleiner als der Primärstrom $I_p$, da man für die Kompensationswicklung eine Spule mit einer Anzahl von $N_S$ Windungen verwendet und dadurch die gleiche Durchflutung ($N_p$ Amperewindungen) erzielt wie im Ringkern des Strom-sensors:

$$N_P \cdot I_P \ = \ N_S \cdot I_S$$

Somit ist die Flussdichte $B_S$ ebenso groß wie die Flussdichte $B_p$, und die Amperewindungen gleichen sich aus. Das System arbeitet daher mit einem magnetischen Fluss von etwa gleich Null, wodurch Probleme, die vom Restmagnetismus herrühren, vermieden werden.

Dies wird nachfolgend kurz an einem Beispiel veranschaulicht, bei dem ein beispielsweise zu messender Gleichstrom 100 A beträgt. Die Windungszahl $N_p$ beträgt 1, denn der stromführende und zu überwachende Leiter führt ohne Windung geradlinig durch den Ringkern. Die Sekundärwicklung weist beispielsweise $N_S$ = 1000 Windungen auf. Das Übersetzungsverhältnis beträgt somit 1:1000. Sobald der Primärstrom $I_p$ beispielsweise einen positiven Wert annimmt, entsteht im Luftspalt des Kerns eine Flussdichte $B_p$, die im Halleement eine Spannung $V_H$ erzeugt. Über die Verstärkerstufe A und die Treiberstufe DS wird in der Sekundärwicklung ein Strom $I_S$ eingespeist, der eine Flussdichte $B_S$ erzeugt, welche die Flussdichte $B_p$ exakt kompensiert. Der resultierende Sekundärstrom $I_S$ beträgt hier:

$$I_S \ = \ N_P \cdot I_P / N_S \ = \ 1 \cdot 100A / 1000 \ = \ 100mA$$

Der Sekundärstrom $I_S$ ist somit das über die Windungszahl der Kompensationswicklung dividierte Abbild des Primärstroms $I_p$ und stellt den Messstrom für die weitere Verarbeitung bei Stromsensoren nach dem Kompensationsprinzip zur Verfügung.

Ein Beispiel eines Stromsensors nach dem Kompensationsprinzip mit Überprüfung dessen ordnungsgemäßer Funktion für sicherheitsrelevante Anwendungen ist in Figur 2 dargestellt. Ein solcher Stromsensor umfasst unter Zugrundelegen des in Figur 1 gezeigten Prinzips einen Hall-Sensor 1, einen Verstärker 2, eine Treiberstufe 3, einen Ringkern 4 mit Luftspalt, eine Kompensationswicklung 5 und einen Widerstand $R_B$, wobei zwei elektrische Leiter 6 und 7 für die Ströme $I_n$ und $I_{test}$ durch den Ringkern 4 geführt sind.

Der Hall-Sensor 1 ist wiederum im Luftspalt des Ringkerns 4 angeordnet. Die für den Betrieb des Hall-Sensors notwendige Einspeisung eines konstanten Stroms ist der Übersichtlichkeit halber in Figur 2 nicht dargestellt. Die vom Hall-Sensor 1 generierte Spannung wird mittels des Verstärkers 2 entsprechend verstärkt. Die dem Verstärker 2 nachfolgende Treiberstufe 3 erzeugt daraus einen Ansteuerungsstrom für die Kompensationswicklung 5. Die Kompensationswicklung 5 ist über den Widerstands $R_B$ an den Ausgang der Treiberstufe 3 angeschlossen. An dem Widerstand $R_B$ fällt eine Spannung ab, die dem Strom durch die Kompensationswicklung und damit durch den Primärleiter 6 entspricht.

Bei der Stromsensoranordnung gemäß Figur 2 ist aber nicht nur der Primärleiter 6 durch den Ringkern geführt, sondern ein zweiter elektrischer Leiter, der einen Strom $I_{test}$ führt und deshalb im folgenden Teststromleiter 7 bezeichnet wird. Dieser zweite elektrische Leiter beziehungsweise der durch diesen fließende Teststrom $I_{test}$ dient zur Überwachung des Stromsensors und zur Bestimmung dessen ordnungsgemäßer Funktion. Zu diesem Zweck wird auf diesen Leiter ein Teststrom $I_{test}$ mit einem bestimmten Verlauf eingeprägt (die entsprechende Ansteuerungsanordnung ist in Figur 2 der Übersichtlichkeit halber nicht dargestellt).

Auf diese Weise ergibt sich am Ausgang in Figur 2 dargestellten Stromsensors ein Strom $I_{out}$, der einem Maß für die Summe der beiden Ströme $I_{test}$ und $I_n$, also einem Maß für die Summe des Stroms im zu messenden und zu überwachenden Stromleiter und des Stroms im Leiter des Teststroms entspricht. Die Berechnungsvorschrift für den Strom $I_{out}$ lautet dabei:

$$I_{out} = (I_{test}+I_n)/N$$

wobei N die Windungszahl der Kompensationswicklung des Stromsensors darstellt (vergleiche hierzu die entsprechenden Ausführungen zu Figur 1). Der Strom $I_{out}$ erzeugt schließlich über dem Widerstand $R_B$ dann die Ausgangsspannung $U_{out}$.

Nachteilig wirkt sich dabei aus, dass der Anteil des Teststroms $I_{test}$ am Gesamtstrom $I_{test}+I_n$ aus dem Strom $I_{out}$ ausgefiltert werden muss, um auf der einen Seite den Teststrom $I_{test}$ entsprechend getrennt auswerten zu können und andererseits den zu messenden und zu überwachenden Strom $I_n$ getrennt zu erhalten und verarbeiten zu können. Dabei stellt die notwendige Ausfilterung des Teststroms $I_{test}$ aus dem Gesamtstrom $I_{out}$ einen zusätzlichen technischen Aufwand und entsprechende Kosten dar. Weiterhin wirkt sich auch nachteilig aus, dass das Einbringen des den Teststrom $I_{test}$ führenden Leiters in den Ringkern sowohl technisch wie auch kostenseitig einen ebenfalls erhöhten Aufwand zur Folge hat.

Darüber hinaus ist auch die erforderliche Trennung des Ausgangsstromes $I_{out}$ der Kompensationswicklung des Stromsensors gemäß Figur 2 in die Ströme $I_{test}/N$ und $I_n/N$ nicht in jedem Fall einfach zu realisieren. Dies ist insbesondere dann der Fall, wenn der zeitliche Verlauf des Stromes $I_n$ nicht vorab bekannt ist und es daher nicht möglich ist, den zeitlichen Verlauf des Teststroms $I_{test}$ vorab so festzulegen, damit dieser leicht vom Verlauf des durch den Stromsensor zu messenden und zu überwachenden Stromes $I_n$ zu unterscheiden ist.

Die ordnungsgemäße Funktion des Stromsensors gemäß Figur 2 wird überprüft, indem der Verlauf des in den Testleiter eingeprägten Stromes $I_{test}$ mit dem aus dem Ausgangssignal $I_{out}$ der Kompensationswicklung ausgefilterten Maß $I_{test}/N$ des Teststromes $I_{test}$ verglichen wird. Abweichungen zwischen diesen Verläufen des eingespeisten Teststromes $I_{test}$ und dem Maß für diesen Teststrom $I_{test}/N$ am Ausgang der Kompensationswicklung des Stromsensors deuten auf eine Fehlfunktion des Stromsensors hin, wobei aus diesem Signal keine beziehungsweise nur sehr aufwendig eine Aussage über die Art der Funktionsstörung abgeleitet werden kann.

Das Prinzipschaltbild eines beispielhaften Stromsensors nach dem Kompensationsprinzip mit Überprüfung dessen ordnungsgemäßer Funktion ist in Figur 3 dargestellt. Gemäß Figur 3 umfasst ein solcher Stromsensor wiederum einen Hall-Sensor 1, einen Verstärker 2, eine Treiberstufe 3, einen Ringkern 4 mit Luftspalt, eine Kompensationswicklung 5 und einen Widerstand $R_B$, wobei im Gegensatz zum Ausführungsbeispiel gemäß Figur 2 nur ein durch den Ringkern geführter elektrischer Leiter, nämlich der den zu messenden und zu überwachenden Strom $I_n$ führende Primärleiter 6 vorgesehen ist. Darüber hinaus wird an dem Knotenpunkt zwischen dem Ausgang der Treiberstufe 3 und einem Ende der Kompensationswicklung mittels einer Stromquelle ein Teststrom $I_{test}$ eingespeist. Die grundlegende Funktion der vorliegenden Sensoranordnung entspricht abgesehen vom Testmodus weitgehend der grundlegenden Funktion der in Figur 2 gezeigten Sensoranordnung.

Da aufgrund der wirkenden Regelmechanismen ein Ausgangsstrom $I_{out}$ unabhängig von $I_{test}$ bleibt, steht der Ausgangsstrom $I_{out}$ (Messstrom )am Ausgang der Kompensationswicklung ohne weitere Zusatzmaßnahmen (vergleiche Aufspaltung in $I_{out}$ und $I_{test}$ am Ausgang der Kompensationswicklung in der Anordnung nach Figur 2) zur Verfügung. Somit kann am Ausgang der Treiberstufe 3 die von dem Teststrom $I_{test}$ herrührende Testspannung ermittelt werden und als Fehlersignal dienen. Die Berechnung des Ausgangsstroms $I_{out}$ am Ausgang der Kompensationswicklung ergibt sich bei der Anordnung nach Figur 3 zu:

$$I_{out} = I_n/N$$

wobei N wiederum für die Windungszahl der Kompensationswicklung steht. Die Berechnung der am Ausgang der Treiberstufe 3 abgreifbaren Testspannung erfolgt gemäß

$$U_{test} = (I_{test}+I_{out}) \cdot (R_i+R_B),$$

wobei $R_i$ der Innenwiderstand der Kompensationswicklung ist.

Alternativ ist auch eine Umkehrung möglich dergestalt, dass eine Testspannung vorgegeben wird und ein sich daraus ergebender Teststrom ausgewertet wird.

Nachteilig wirkt sich bei der Anordnung gemäß Figur 3 aus, dass zusätzliche Anschlüsse bzw. Anschlussleitungen zur Ausgabe der Testspannung $U_{test}$ (oder im alternativen Fall des Teststroms $I_{test}$) erforderlich sind. Zusätzliche Anschlüsse bedeuten jedoch wiederum einen erhöhten Aufwand, erhöhte Kosten und erhöhte Komplexität.

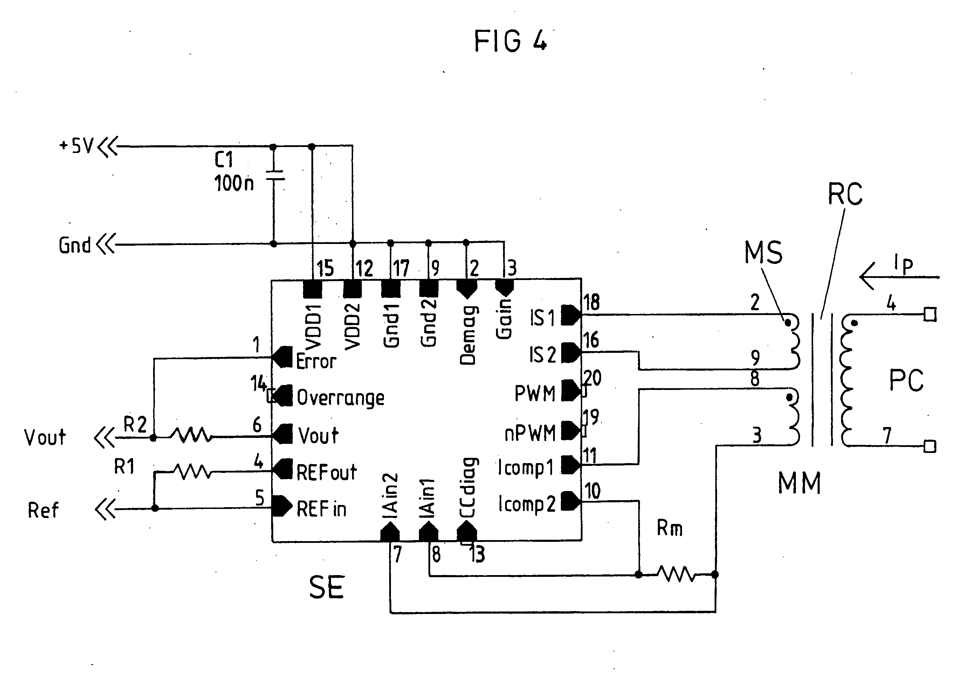

Die Erfindung sieht nun vor, durch geschickte Überlagerung eines vorhandenen analogen Ein- und/oder Ausgangs eines Stromsensors mit Signalen, die aus einem in der Auswerteschaltung intern erzeugten Fehlersignal ohne zusätzliche Verkabelung zur Weiterverarbeitung zur Verfügung zu stellen. Die in Verbindung mit den Figuren 4 bis 9 nachfolgend beschriebenen Prinzipien und Ausführungsformen der vorliegenden Erfindung sind dabei sowohl auf direkt abbildende Stromsensoren wie auch auf Stromsensoren nach dem Kompensationsprinzip anwendbar, die analoge Signale erhalten oder zur Verfügung stellen.

In den sämtlichen Anordnungen der Figuren 4 bis 7 wird der Einfachheit halber immer von einem beispielsweise als integrierter Schaltkreis ausgeführte Baustein SE ausgegangen, der vom Prinzip her in etwa aufgebaut ist wie die in Figur 3 gezeigte Anordnung, jedoch anstelle eines Hall-Sensors einen magnetischen Sensor MS aufweist der neben der Kompensationswicklung CW, dem Primärleiter PC und dem Ringkern RC Teil eines magnetischen Moduls MM sind. Weiterhin stellt der Baustein SE Funktionen zur Feststellung von Fehlfunktion und Überlastung des Stromsensors sowie zur Unterdrückung von unerwünschtem Rauschen zur Verfügung. Darüber hinaus umfasst der Baustein Funktionen zum Demagnetisieren des Stromsensors, die beim Einschalten der Anordnung oder nach Bedarf durchgeführt werden kann, um die höchst mögliche Messgenauigkeit der aus Stromsensoranordnung zu erzielen.

Der Baustein SE umfasst hierzu beispielsweise Anschlüsse 1 bis 20 mit den nachfolgend aufgeführten Merkmalen. Anschluss 1 (Error) stellt über einen Open-Drain- oder Open-Collector-Ausgang ein Fehlersignal (Error Flag) zur Verfügung, Anschluss 2 (Demag) stellt den Steuerungseingang für die optionale Demagnetisierung des Stromsensors dar und Anschluss 3, (Gain) stellt den Steuerungseingang zur Einstellung der Kreisverstärkung dar, wobei ein Logikpegel "low" beispielsweise eine übliche Kreisverstärkung und ein Logikpegel "high" eine demgegenüber um -8 dB abgeschwächte Kreisverstärkung einstellt. Anschluss 4 ($REF_{out}$) stellt am Ausgang eine interne Referenzspannung von beispielsweise +2,5 V zur Verfügung. Anschluss 5 ($REF_{in}$) bildet einen Eingang für die Nullreferenz eines internen Differenzverstärkers und Anschluss 6, (Vout) stellt das Ausgangssignal des internen Differenzverstärkers nach außen zur Verfügung. Anschlüsse 7 und 8 (IAin1, IAin2) führen Eingangsanschlüsse des internen Differenzverstärkers nach außen, wobei IAin1 den nicht invertierenden Eingang des internen Differenzverstärkers und IAin2 den invertierenden Eingang des internen Differenzverstärkers darstellen. Anschluss 9 (Gnd2) ist ein Masseanschluss und wird in einer üblichen Beschaltung mit dem Anschluss 17 (Gnd1) verbunden. Anschlüsse 10 und 11 (Icomp2, Icomp1) stellen die entsprechenden Ausgangssignale einer internen Treiberstufe für die Kompensationsspule des Stromsensors zur Verfügung. Anschluss 12 (VDD2) dient zum Anschluss einer Versorgungsspannung und wird in einer üblichen Beschaltung, mit dem Anschluss 15 (VDD1) verbunden. Anschluss 13 (CCdiag) bildet einen Steuerungseingang zur Feststellung eines möglichen Bruchs im Draht der Kompensationswicklung, wird jedoch bei den Anordnungen der Figuren 4 bis 7 nicht verwendet und ist daher auch nicht beschaltet.

Ferner sind vorgesehen ein mit "Overrange" bezeichneter Anschluss 14, der mit einem internen Open-Drain- oder Open-Collector-Ausgang zur Signalisierung eines Überschreitens des zulässigen Messbereiches in Verbindung steht, wobei hier der logische Pegel "low" den Zustand des Überschreitens des zulässigen Messbereiches anzeigt. Anschlüsse 18 und 16 (IS1, IS2) dienen zum Anschluss des magnetischen Stromsensors MS dar, der Teil des magnetischen Moduls MM ist. Die verbleibenden Anschlüsse 19 und 20 stellen die Ausgangssignale der Messsonde des Stromsensors als pulsweitenmodulierte Signale zur Verfügung, wobei an Anschluss 19 (nPWM) das pulsweitenmodulierte Signal in invertierter Form und an Anschluss 20 (PWM) das pulsweitenmodulierte Signal in nicht invertierter Form anliegt. Die Signale der beiden Anschlüsse 19 und 20 werden in den Ausführungsbeispielen der Figuren 4 bis 7 nicht verwendet und sind daher auch nicht beschaltet.

Wie bereits weiter oben kurz dargestellt, stellt der Baustein SE zwei Signale zur Verfügung, die einen nicht ordnungsgemäßen Zustand der Gesamtanordnung zur Messung und Überwachung von Strömen anzeigen. Das erste Signal Overrange am Anschluss 14 zeigt dabei an, dass der interne Differenzverstärker des Bausteins SE in Folge von beispielsweise einem sehr hohen Spitzenstrom in dem vom Stromsensor zu überwachenden Stromleiter in den Bereich der Begrenzung (Überlastbetrieb) gesteuert wird und kein für den tatsächlich fließenden Strom repräsentatives Signal mehr liefern kann. Dabei wird der Zustand des Überschreitens des maximal möglichen Messbereichs durch einen Logikpegel "low" am Anschluss 14 des Bausteins SE signalisiert.

Der Anschluss 14 kehrt zum Logikpegel "high" zurück, sobald die Bedingungen für ein Übersteuern der Anordnung nicht mehr gegeben sind und die Stromsensoranordnung in den normalen Betriebsmodus zurückgekehrt ist. Zu diesem Zweck ist beispielsweise eine Beschaltung des Anschlusses 14 für das Overrange-Signal mit einem Pull-Up-Widerstand zweckmäßig, die weiter unten detaillierter in Figur 9 dargestellt wird. Das auf diese Weise an Anschluss 14 erzeugte Overrange-Signal kann in einer nachgeschalteten Anordnung dazu verwendet werden, um diese beispielsweise vorübergehend abzuschalten oder den durch sie fließenden Strom in geeigneter Weise zu reduzieren.

Zusätzlich zum Overrange-Signal an Anschluss 14 stellt der Baustein SE an Anschluss 1 das Error-Signal zur Verfügung. Das Fehlersignal Error signalisiert Zustände der Stromsensoranordnung, in denen die über Anschluss 6 ausgegebene analoge Spannung Vout nicht den durch den zu überwachenden Stromleiter fließenden Strom Ip repräsentiert. Ein Fehlerzustand wird auch dann angezeigt, wenn ein Demagnetisierungszyklus durchlaufen wird, wenn die Versorgungsspannung (VDD1, VDD2) einbricht oder wenn es zu Ausfällen in den elektromagnetischen Komponenten der Stromsensoranordnung kommt. Weiterhin wird auch ein Fehlerzustand signalisiert, wenn im Stromkreis der Messsonde ein Kurzschluss oder eine Unterbrechung auftreten. Alle der vorgenannten Zustände führen dazu, dass das Ausgangssignal Vout am Anschluss 6 nicht den tatsächlich durch den zu überwachenden Stromleiter fließenden Strom repräsentiert.

Beispielsweise führen die nachfolgend beschriebenen Zustände zu der Aktivierung des Fehlersignals Error, wobei ein Fehlerzustand durch einen Logikpegel "low" am Anschluss 1 des Bausteins SE repräsentiert wird, wenn nachfolgend beschriebene Zustände eintreten:

1. Ein Stromkomparator für die Messspule verbleibt für mehr als eine vorgegebene erste Zeitspanne auf dem Logikpegel "low". Dieser Zustand tritt auf, wenn die Verbindung zur Messspule unterbrochen ist oder wenn die Versorgungsspannung unter einen Wert abfällt, bei dem der erforderliche Sättigungsstrom nicht mehr erreicht werden kann. Während der vorgegebenen ersten Zeitspanne verbleibt der Treiber für Icomp aktiv, wird aber nach Ablauf der vorgegebenen ersten Zeitspanne inaktiv geschaltet. Im Falle der Wiederherstellung des Normalbetriebs weist das Logiksignal des Anschlusses 1 den Wert "low" auf und der Treiber für Icomp verbleibt für einen vorgegebenen zweiten Zeitraum inaktiv.

2. Die Pulsweite des Treibers für eine Messspule mit Weicheisenkern beträgt über drei aufeinander folgende Perioden weniger als ein vorgegebener dritter Zeitraum. Dieser Zustand signalisiert entweder eine kurzgeschlossene Messspule oder einen vollständig gesättigten Sensor zum Zeitpunkt des Einschaltens der Anordnung. Wenn dieser Zustand länger als einen vorgegebenen vierten Zeitraum andauert und erst dann wieder in den Normalzustand zurückkehrt, verbleibt das Fehlersignal Error auf dem Logikpegel "low" und der Strom Icomp wird für einen vorgegebenen fünften Zeitraum im Zustand des Reset gehalten. Wenn dieser Zustand weniger als vorgegebener sechster Zeitraum andauert, wird das Fehlersignal Error sofort wieder zurückgesetzt und der Treiber für den Strom Icomp wird nicht unterbrochen.

3. Wenn der Demagnetisierungszyklus während eines Durchlaufs vorzeitig abgebrochen wird, in dem das Eingangssignal Demag an Anschluss 2 auf den Logikwert "low" eingestellt wird, verbleibt das Fehlersignal Error für vorgegebenen siebten Zeitraum auf dem Logikwert "low" (der Strom Icomp ist in diesem Zeitraum deaktiviert).

4. Für einen vorgegebenen achten Zeitraum wird eine Unterbrechung in der Verbindung zur Kompensationsspule des Stromsensors festgestellt. Es ist anzumerken, dass in diesem Fall der Treiber für die Messsonde und der Treiber für Icomp im normalen Betriebszustand weiterarbeiten und nur das Fehlersignal Error aktiviert wird. Dieser Zustand zeigt an, dass nicht genug Strom durch den Ausgang des Treibers für den Strom Icomp fließt. Ein solcher Zustand kann auftreten, wenn die Kompensationsspule der Stromsensoranordnung einen unzulässig hohen Widerstand aufweist.

5. Wenn die Versorgungsspannung VDD1 nach dem Einschalten der Stromsensoranordnung die Schwelle von beispielsweise +4 V übersteigt, verbleibt das Fehlersignal Error für vorgegebenen neunten Zeitraum auf dem Logikwert "low".

6. Der Zustand einer zu niedrigen Versorgungsspannung dauert länger als ein vorgegebener zehnter Zeitraum. Die Rückführung in den Normalbetrieb erfolgt auf die gleiche Weise wie beim Einschalten der Anordnung.

Die oben genannten Zeiträume können dabei alle gleich oder unterschiedlich oder teilweise gleich bzw. unterschiedlich sein.

Bei der Anordnung nach Figur 4 weist die erfindungsgemäße Stromsensoranordnung externe Anschlüsse auf, nämlich einen Anschluss für die Versorgungsspannung (+5 V), einen Anschluss für Masse, (Gnd), sowie zwei Anschlüsse für Ausgangssignale Ref und Vout. Anschlüsse 4 und 7 des magnetischen Moduls MM für den zu messenden und zu überwachenden Strom Ip sind dabei ebenfalls als externe Anschlüsse der Stromsensoranordnung zu betrachten. Bei der Anordnung nach Figur 4 ist neben dem Baustein SE das magnetische Modul MM, Widerstände R1, R2 und Rm sowie ein Kondensator C1 vorgesehen. Das magnetische Modul MM umfasst den Primärleiter PC zwischen den Anschlüssen 4 und 7, die Kompensationsspule CW zwischen den Anschlüssen 3 und 8 sowie die magnetische Messsonde MS zwischen den Anschlüssen 2 und 9. Dabei sind der erste Anschluss 2 der Messsonde MS mit dem Anschluss 18 (IS1) des Bausteins SE verbunden und der zweite Anschluss 9 der Messsonde MS ist mit dem Anschluss 16 (IS2) des Bausteins SE verbunden. Weiterhin ist der Anschluss 8 der Kompensationsspule CW des Stromsensormoduls mit dem Anschluss 11 (Icomp1) und der Anschluss 3 der Kompensationsspule CW ist über den Widerstand Rm mit dem Anschluss 10 (Icomp2) verbunden. Anschluss 3 der Kompensationsspule CW ist mit Anschluss 7 (IAin2) verbunden und Anschluss 8 (IAin1) ist direkt mit Anschluss 10 (Icomp2) und unter Zwischenschaltung des Widerstandes Rm mit Anschluss 3 der Kompensationsspule CW verbunden.

Weiterhin sind Anschluss 2 (Demag), Anschluss 3 (Gain), Anschluss 9 (Gnd2) und Anschluss 17 (Gnd1) einerseits untereinander und andererseits mit dem externen Masseanschluss Gnd verbunden. Anschlüsse 12 und 15 (VDD2, VDD1) sind untereinander und mit dem externen Versorgungsspannungsanschluss (+5V) verbunden. Der Kondensator C1 ist zwischen dem externen Versorgungsspannungsanschluss (+5V) und dem externen Masseanschluss Gnd geschaltet. Anschluss 4 (REFout) ist mit einem Anschluss des Widerstands R1 verbunden, der mit seinem anderen Anschluss sowohl mit Anschluss 5 (REFin)des Bausteins SE als auch mit einem externen Anschluss Ref verbunden, d. h. Anschluss 5 (REFin) ist direkt mit dem externen Anschluss Ref verbunden. Anschluss 6 (Vout) ist mit einem Anschluss des Widerstands R2 verbunden, dessen anderer Anschluss mit dem externen Anschluss Vout verbunden ist.

An die Anschlüsse 18, 16 (IS1, IS2) des Bausteins SE ist die im Luftspalt des Ringkerns angeordnete Magnetfeldsonde angeschlossen, die beispielsweise als Spule mit einem weichmagnetischen Kern ausgeführt ist. Aus der Reaktion der Magnetfeldsonde auf einen von dem Strom Ip erzeugten Magnetfeld wird im Baustein SE der Kompensationsstrom Icomp erzeugt, mit dem die Kompensationsspule (Anschlüsse 3 und 8 des magnetischen Moduls) über die Anschlüsse 10 und 11 (Icomp2, Icomp1) und dem dazwischen geschalteten Widerstand Rm angesteuert wird. Die Erzeugung des Kompensationsstroms erfolgt dabei in ähnlicher Weise wie bei der Anordnung aus Figur 1. Der in die Kompensationsspule eingespeiste Kompensationsstrom Icomp stellt, wie beispielsweise in Zusammenhang mit Figur 1 beschrieben, ein exaktes Abbild des durch den stromführenden Leiter fließenden, zu messenden Stroms Ip dar. Die diesem Kompensationsstrom Icomp entsprechende und damit ein Maß für diesen Kompensationsstrom bildende Ausgangsspannung Vout steht an dem Anschluss 6 zur weiteren Verarbeitung durch nachgeschaltete Anordnungen zur Verfügung.

Wie weiter oben beschrieben, ist es aus verschiedenen Gründen wie Kosten, Komplexität, Baugröße, Verdrahtungsaufwand und Ähnlichem wünschenswert, die Anzahl der elektrischen Leitungen von und zu einer Stromsensoranordnung so gering wie möglich zu halten. Erfindungsgemäß ist nun vorgesehen, dass weder das Fehlersignal am Anschluss 1 des Bausteins SE noch das Overrange-Signal am Anschluss 14 des Bausteins SE als eigenständige externe Anschlüsse der Stromsensoranordnung zur Verfügung stehen und trotzdem eine nachgeschaltete Auswertung von Fehlerzuständen und unerwünschten Betriebszuständen der Stromsensoranordnung möglich ist. Dazu ist bei der Anordnung nach Figur 4 der Anschluss 1 (Error) des Bausteins SE ebenfalls mit dem externen Anschluss Vout verbunden, an dem das Signal des Anschlusses 6 des Bausteins SE über den Widerstand R2 angelegt ist und wird auf diese Weise dem Ausgangssignal für die Messspannung Vout überlagert. Auf die dargestellte Weise kann das Signal Error (Anschluss 1 des Bausteins SE) ohne einen zusätzlich externen Ausgang der Stromsensoranordnung nach außen geführt werden und damit einer weitergehenden Verarbeitung durch nachgeschaltete externe Komponenten zugeführt werden. Bei der gezeigten Anordnung liegt die Messspannung Vout in Abwesenheit eines durch den zu messenden elektrischen Leiter fließenden Strom (Ip = 0) auf einem von Null verschiedenen Referenzpotential und weicht bei einem von Null unterschiedlichen Primärstrom Ip proportional von diesem Referenzpotential ab. Tritt nun ein Fehlerzustand auf, wird das Fehlersignal Error am Anschluss 1 des Bausteins SE über dessen Open-Collector-Ausgang auf den Logikpegel "low", das heißt auf Masse (Gnd) gezogen. Das bedeutet aber wiederum, dass dann auch die Messspannung Vout am externen Anschluss für Vout auf Masse (Gnd) gezogen wird.

Damit steht in einem Fehlerfall überhaupt kein Messsignal der Stromsensoranordnung mehr zur Verfügung. Das Ausgangssignal kann keinem bestimmten Primärstrom mehr zugeordnet werden und ist damit beispielsweise auch für nachgeschaltete Anordnungen als Fehler erkennbar und daher nicht mehr nutzbar. Ein Ausgangssignal Vout = 0 V entspricht daher eindeutig einem Fehlerfall und signalisiert einer nachgeschalteten Auswerteanordnung, dass beispielsweise der Primärstrom Ip durch den zu messenden elektrischen Leiter außerhalb des zulässigen Messbereiches liegt oder einer der im Zusammenhang mit dem Fehler Signal weiter oben erläuterten Fehlerzustände vorliegt. Allerdings ist hierbei der darstellbare Messbereich begrenzt, da die "Ränder" des Messbereichs zur Fehlersignalisierung benötigt werden.

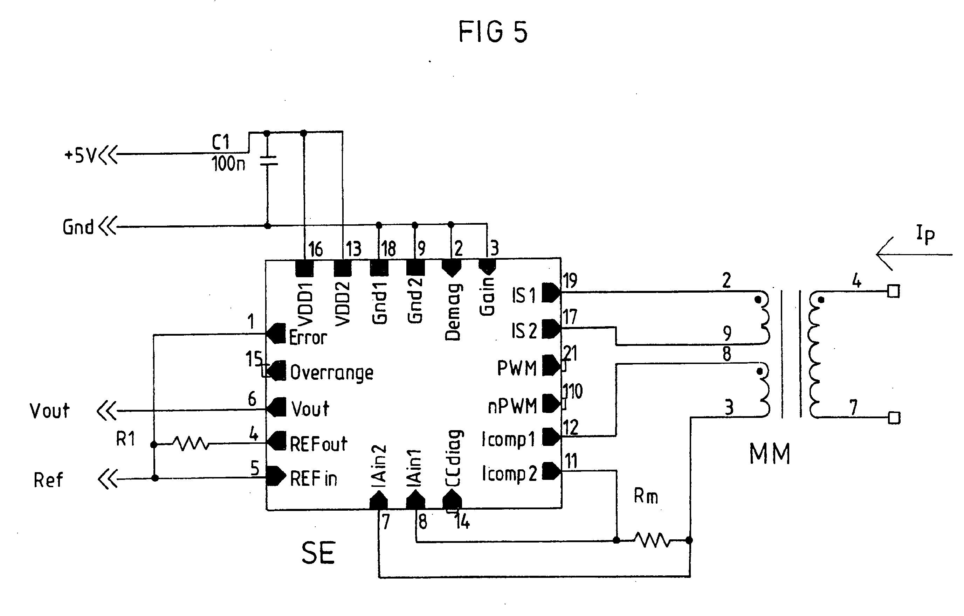

Ausgehend von der in Figur 4 gezeigten Anordnung wird erfindungsgemäß das nach außen geführte Referenzsignal Ref zur Fehlersignalisierung verwendet wie beim Ausführungsbeispiel nach Figur 5 gezeigt. Auf diese Weise ist eine Stromsensoranordnung realisierbar, die ebenfalls ein auswertbares Fehlersignal zur Verfügung stellt ohne dabei zusätzliche Anschlüsse der Stromsensoranordnung zu benötigen und ohne darstellbaren Messbereich zu verkleinern. Die Anschlussbelegung und die Beschaltung sind also die gleichen wie in Figur 4, außer dass in Figur 5 sich im Pfad des Ausgangssignal Vout (Anschluss 6 des Bausteins SE) kein Widerstand R2 befindet und Anschluss 1 (Error) des Bausteins SE nicht mit dem externen Anschluss Vout verbunden ist, sondern mit dem externen Referenzeingang Ref der Stromsensoranordnung und damit mit dem Anschluss 5 (REFin) des Bausteins SE direkt sowie über den Widerstand R1 mit dem Anschluss 4 (REFout) des Bausteins SE verschaltet ist.

Ohne die Übermittlung eines Fehlersignals könnte beispielsweise eine Unterbrechung im elektrischen Leiter der Kompensationswicklung des Stromsensors dazu führen, dass das Ausgangssignal Vout auf dem Potential der Referenzspannung der Anordnung verbleibt, obwohl der zu messende Strom unerwünscht hohe Werte erreicht und eventuell schädigende Wirkungen ausübt. Dabei könnte beispielsweise eine notwendige Sicherheitsabschaltung einer stromführenden Anordnung ausbleiben, wodurch es zu großen Schäden kommen könnte. Beim Ausführungsbeispiel nach Figur 5 wird dem Eingangs- und/oder dem Ausgangssignal der Referenzspannung der Stromsensoranordnung überlagert. Dies hat zur Folge, dass in einem Fehlerfall, wenn der Logikpegel des Fehlersignals am Anschluss 1 des Bausteins SE auf "low" geht, der Anschluss für die Referenzspannung Ref auf Masse Gnd gezogen wird. Damit kann ein Fehlerzustand am Ausgang für die Referenzspannung signalisiert werden.

Die im Baustein SE intern erzeugte Referenzspannung beträgt beispielsweise +2,5 V. Damit können im eingeschwungenen Zustand am Ausgang der Stromsensoranordnung nur zwei Spannungen auftreten. Im Normalbetrieb, wenn kein vom Baustein SE erkannter Fehlerzustand vorliegt, beträgt die Spannung am Ausgang des Stromsensors +2,5 V. Im Fehlerfalle ist die Spannung am Ausgang des Stromsensors ungleich +2,5V, in der Regel 0V, da die Referenz auf 0V gesetzt ist und die Messspannung entsprechend auf 0V geregelt wird.

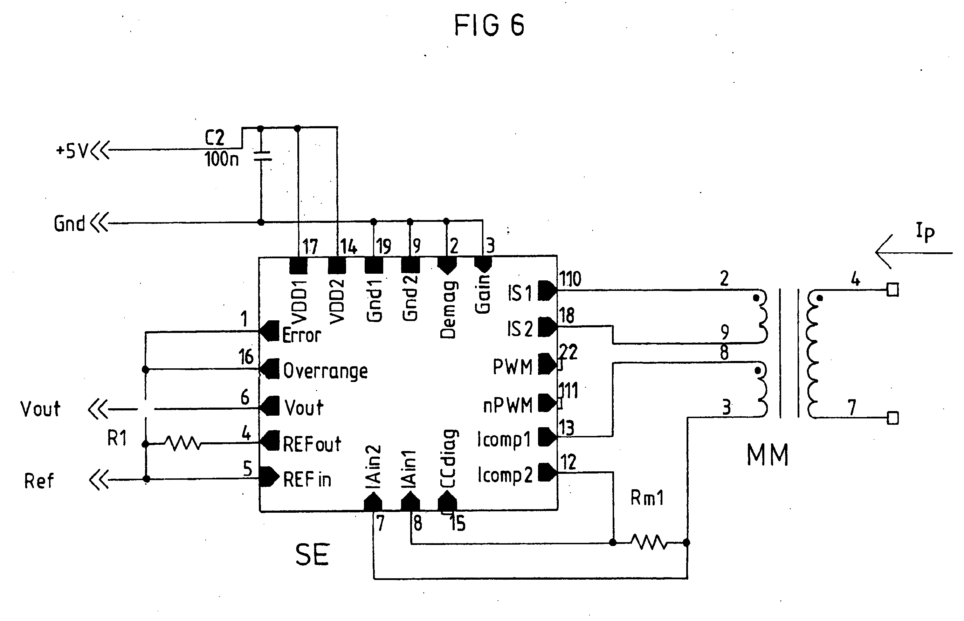

Eine weiteres Ausführungsbeispiel einer Stromsensoranordnung gemäß der vorliegenden Erfindung ist in Figur 6 dargestellt. Dabei umfasst die Anordnung nach Figur 6 die aus der Figur 5 bekannten Komponenten. Hinzu kommt jedoch noch eine Verbindung zwischen dem externen Anschluss Ref und dem Anschluss 16 (overrange) des Bausteins SE.

Die Zusammenlegung der Signale Error und Overrange in Verbindung über deren jeweilige Open-Colector-Ausgänge entspricht einer ODER-Verknüpfung der beiden Signale. Dies bewirkt, dass beide Signale der Referenzspannung Ref überlagert werden können, wodurch die Signalisierung eines Fehlers für einen weiteren Bereich von Fehlern erfolgt. Im Normalbetrieb, wenn kein vom Baustein SE erkannter Fehlerzustand Error oder Overrange vorliegt, beträgt die Spannung Ref am Ausgang der Stromsensoranordnung +2,5 V. Wird durch eines der oder beide Fehlersignale Error oder Overrange Fehlerzustand angezeigt, wird der Anschluss Ref wiederum auf Masse gezogen und so der Fehlerzustand nun auch unter Einschluss der Overrange-Überwachung nach außen signalisiert.

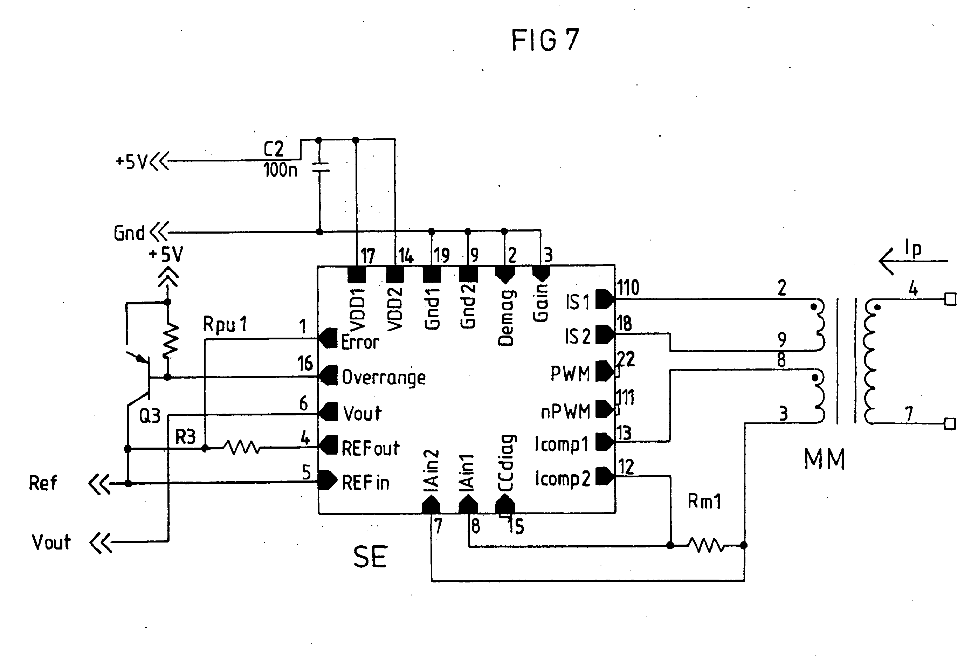

Bei der Anordnung gemäß Figur 7 werden wiederum die aus den Figuren 4, 5 und 6 bekannten Komponenten des Auswertebausteins SE und des magnetischen Moduls MM verwendet. Die Anschlussbelegung sowie die Beschaltung dieser Komponenten und die Verbindungen zwischen diesen Komponenten sind die Gleichen wie in Figur 6, außer dass bei der Anordnung nach Figur 7 in den Pfad des Overrange-Signals zwischen dem Anschluss 14 des Bausteins SE und dem externen Anschluss für die Referenzspannung Ref ein Inverter mit Open-Collector-Ausgang gegen Masse eingefügt ist.

Der Inverter umfasst einen pnp-Transistor Q3 und einen Widerstand Rpu1. Dabei ist der Collector des pnp-Transistors Q3 mit dem extern Anschluss für die Referenzspannung Ref verbunden. Die Basis des pnp-Transistors Q3 ist mit dem das Signal Overrange führenden Anschluss 16 des Bausteins SE verbunden. Der Emitter des pnp-Transistors Q3 ist mit einer positiven Versorgungsspannung verbunden, die im vorliegenden Beispiel +5 V beträgt. Der Widerstand Rpu1 ist zwischen diese Versorgungsspannung und die Basis des pnp-Transistors Q3 geschaltet.

Auf diese Weise wird das über den Anschluss 16 des Bausteins SE zur Verfügung gestellte Ausgangssignal Overrange invertiert, bevor es dem Ausgangssignal Ref der Referenzspannung überlagert wird. Dabei nimmt das Signal Overrange nach der Invertierung den Spannungspegel von +5 V an, wenn aufgrund eines erkannten Fehlerzustandes der Baustein SE ein Logiksignal mit dem Pegel "low" (0V) als Overrange-Signal ausgibt. Wenn kein Fehlerzustand vorliegt und das Overrange Signal einen Logikpegel "high" (+5V) aufweist, bleibt aufgrund der Wirkung des Open-Collector-Ausgangs das Referenzsignal Ref unbeeinflusst durch das Overrange-Signal. Damit lassen sich die beiden Fehlerzustände Error und Overrange eindeutig unterscheiden, da Ref dem Error-Zustand und +5V dem Overrange-Zustand entspricht gegenüber dem Normalzustand von +2,5 V, wobei auch hier keine zusätzlichen Leitungen benötigt werden.

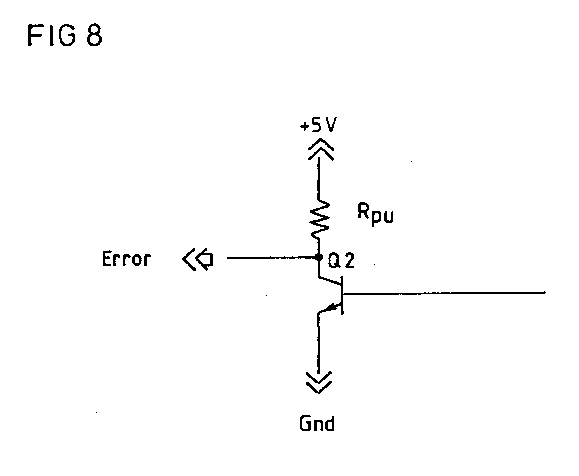

Figur 8 zeigt eine alternative Ausführungsform eines Inverters mit einem npn-Transistor und einem Open-Collector-Ausgang, der jedoch über einen Pull-Up-Widerstand Rpu gegen +5 V arbeitet. Die in den Figuren 7 und 8 gezeigte Beschaltung mit einem Inverter kann auf gleiche Weise alternativ anstelle beim Overrange-Signal entsprechend auch beim Error-Signal eingesetzt werden.

Somit wird das Ziel der vorliegenden Erfindung erreicht, bei minimaler Anzahl von externen Anschlüssen den analogen Ausgangssignalen (hier Referenzspannung Ref oder Messspannung Vout) einer Stromsensoranordnung die Signale für Fehlerzustände der Anordnung auf eine Weise zu überlagern, dass diese ohne zusätzliche Anschlüsse von nachgeschalteten Anordnungen ausgewertet werden können. Bei einer Ausführungsform kann dabei sogar zwischen den unterschiedlichen Fehlerzuständen Error und Overrange unterschieden werden, obwohl beide der Signale über die gleiche Anschlussleitung nach außen geführt werden.

Abschließend sei noch darauf hingewiesen, das sowohl das magnetische Modul und das Elektronikmodul jeweils für sich als auch miteinander sowie unter Miteinbeziehung weiterer Bauelemente als Baugruppen und insbesondere als hermetisch verschlossene Baugruppen ausgeführt werden können.

**Patentansprüche**

1. Stromsensoranordnung

   mit einem magnetischen Modul (PC, RC, AG, CW) zur Erzeugung eines zu einem ihm zugeführten, zu messenden Strom (/p) proportionales, potentialfreies Signal (/s, /out) erzeugt und
   mit einem mit dem magnetischen Modul (PC, RC, AG, CW) elektrisch gekoppelten Elektronikmodul (S, A, DS) zur Auswertung des potentialfreien Signals vom magnetischen Modul (PC, RC, AG, CW) und Erzeugen eines zum messenden Strom (/p) proportionalen analogen Ausgangsspannung ($V_M$, $U_{out}$, $V_{out}$) aus dem potentialfreien Signal (/s, /out), wobei
   das Elektronikmodul (CS, A, DS) einen Referenzspannungseingang (REFin) zur Einprägung einer Referenzspannung (Ref) von außen oder einen Referenzspannungsausgang (RETout) zum Herausführen der Referenzspannung (Ref) nach außen oder beides, Referenzapannungseingang (REFin) und Referenzspannungsausgang (REFout), aufweist, und
   das Elektronikmodul (CS, A, DS) bei Auftreten mindestens einer Fehlfunktion mindestens ein Fehlersignal (Error, Overrange) erzeugt, **dadurch gekennzeichnet, dass**
   das mindestens ein Fehlersignal (Error, Overrange) der Referenzspannung (REF) am Referenzspannungseingang (REfin) oder Referenzspannungsausgang (REFout) oder an beiden überlagert wird.

2. Stromsensoranordnung nach Anspruch 1, bei der das oder die Fehlersignale (Error, Overrange) mittels jeweils eines Open-Drain- oder Open-Collector-Ausgangs der Referenzspannung (Ref) überlagert wird/werden.

3. Stromsensoranordnung nach Anspruch 2, bei der die Referenzspannung (Ref) über einen Widerstand (Rpu, Rpu1) an die Ausgänge des jeweiligen Open-Drain- oder Open-Collector-Ausgangs gekoppelt ist.

4. Stromsensoranordnung nach Anspruch 2 oder 3, bei der die Open-Drain- oder Open-Collector-Ausgänge derart ausgebibdet sind, dass für unterschiedliche Fehlersignale (Error, Overrange) die Referenzspannung (Ref) auf unterschiedliche Spannungswerte gezogen wird.

5. Stromsensoranordnung nach Anspruch 4, bei der zwei unterschiedliche Fehlersignale (Error, Overrange) vorgesehen sind, wobei die Referenzspannung (Ref) bei dem einen Fehlersignal (Error, Overrange) gegen Masse (Gnd) und bei dem anderen (Overrange, Error) gegen eine Versorgungsspannung (+) gezogen wird.

6. Stromsensoranordnung nach Anspruch 5, bei der die Open-Drain- oder Open-Collector-Ausgänge der beiden Fehlersignale (Error, Overrange) zueinander gegenphasige Signale abgeben.

7. Stromsensoranordnung nach einem der vorherigen Ansprüche, bei der ein Fehlersignal (Error) eine Fehlfunktion des Elektronikmoduls (CS, A, DS) oder des magnetischen Moduls (PC, RC, AG, CW) signalisiert.

8. Stromsensoranordnung nach einem der vorherigen Ansprüche, bei der ein Fehlersignal (Overrange) einen Uberlastbetrieb des Elektronikmoduls (CS, A, DS) oder des magnetischen Moduls (PC, RC, AG, CW) signalisiert.

**9.** Stromosensoranordnung nach einem der vorherigen Ansprüche, bei der magnetisches Modul (PC, RC, AG, CW) und Elektronikmodul (CS, A, DS) einen Kompensationsstromsensor bilden.

**10.** stromsensoranordnung nach einem der Ansprüche 1 bis 8, bei der magnetisches Modul (PC, RC, AG, CW) und Elektronikmodul (CS, A, DS) einen direktabbildenden Stromsensor bilden.

## Claims

**1.** Current sensor arrangement
with a magnetic module (PC, RC, AG, CW) for generating a potential-free signal (/s, /out) proportional to a current (/p) to be measured and supplied to it/and
with an electronic module (S, A, DS) electrically coupled to the magnetic module (PC, RC, AG, CW) for evaluating the potential-free signal from the magnetic module (PC, RC, AG, CW) and generating an analog output voltage (($V_M$, $U_{out}$, $V_{out}$) proportional to the current (/p) to be measured from the potential-free signal (/s, /out), whereby the electronic module (CS, A, DS) comprises a reference voltage input (REFin) for impressing a reference voltage (Ref) from the outside or comprises a reference voltage output (REFout) for leading the reference voltage (Ref) out or comprises both, reference voltage input (REFin) and reference voltage output (REFout), and the electronic module (CS, A, DS) generates at least one error signal (Error, Overrange) upon the occurrence of at least one error function, **characterized in that** the at least one error signal (Error, Overrange) of the reference voltage (REF) is superposed on the reference voltage input (REFin) or the reference voltage output (REFout) or on both.

**2.** The current sensor arrangement according to claim 1, in which the error signal or error signals (Error, Overrange) is/are superposed by an open-drain- or open-collector output of the reference voltage (Ref).

**3.** The current sensor arrangement according to claim 2, in which the reference voltage (Ref) is coupled via a resistor (Rpu, Rpu1) to the outputs of the particular open-drain- or open-collector output.

**4.** The current sensor arrangement according to claim 2 or 3, in which the open-drain or open-collector outputs are constructed in such a manner that reference voltage (Ref) is drawn at different voltage values for different error signals (Error, Overage).

**5.** The current sensor arrangement according to claim 4, in which two different error signals (Error, Overage) are provided, whereby the reference voltage (Ref) is drawn against ground (Gnd) for the one error signal (Error, Overage) and for the other one (Overage, Error) a supply voltage (+) is drawn.

**6.** The current sensor arrangement according to claim 5, in which the open-drain- or open-collector outputs of the two error signals (Error, Overage) emit signals that are opposite in phase to one another.

**7.** The current sensor arrangement according to one of the previous claims, in which an error signal (Error) signals an error function of the electronic module (CS, A, DS) or of the magnetic module (PC, RC, AG, CW).

**8.** The current sensor arrangement according to one of the previous claims, in which an error signal (Overrange) signals an overload operation of the electronic module (CS, A, DS) or of the magnetic module (PC, RC, AG, CW).

**9.** The current sensor arrangement according to one of the previous claims, in which the magnetic module (PC, RC, AG, CW) and the electronic module (CS, A, DS) form a compensation current sensor.

**10.** The current sensor arrangement according to one of claims 1 to 8, in which the magnetic module (PC, RC, AG, CW) and the electronic module (CS, A, DS) form a direct-imaging current sensor.

## Revendications

**1.** Arrangement de capteur de courant
doté d'un module magnétique (PC, RC, AG, CW) permettant de produire un signal exempt de potentiel (/s, /out) proportionnel à un courant (/p) à mesurer et à conduire jusqu'à celui-ci/et doté d'un module électronique (S, A, DS) couplé électriquement au module magnétique (PC, RC, AG, CW) pour évaluer le signal exempt de potentiel à partir du module magnétique (PC, RC, AG, CW) et pour produire une tension analogique de sortie ($V_M$, $U_{out}$, $V_{out}$) proportionnelle au courant (/p) à mesurer à partir du signal exempt de potentiel (/s, /out), moyennant quoi le module électronique (CS, A, DS) comprend une entrée de tension de référence (REFin) permettant d'imprimer une tension de référence (Ref) à partir de l'extérieur, ou comprend une sortie de tension de référence (REFout) permettant de faire sortir la tension de référence (Ref), ou comprend les deux, une entrée de tension de référence (REFin) et une sortie de tension de référence (REFout), et

le module électronique (CS, A, DS) produit au moins un signal d'erreur (Erreur, Dépassement) lors de l'occurrence d'au moins une fonction d'erreur, **caractérisé en ce que**

l'au moins un signal d'erreur (Erreur, Dépassement) de la tension de référence (REF) se superpose sur l'entrée de tension de référence (REFin) ou sur la sortie de tension de référence (REFout) ou sur les deux.

2. Arrangement de capteur de courant selon la revendication 1, dans lequel le signal d'erreur ou les signaux d'erreur (Erreur, Dépassement) est/sont superposé(s) par une sortie à drain ouvert ou à collecteur ouvert de la tension de référence (Ref).

3. Arrangement de capteur de courant selon la revendication 2, dans lequel la tension de référence (Ref) est couplée par le biais d'une résistance électrique (Rpu, Rpu1) aux sorties de la sortie particulière à drain ouvert ou à collecteur ouvert.

4. Arrangement de capteur de courant selon la revendication 2 ou 3, dans lequel les sorties à drain ouvert ou à collecteur ouvert sont construites de manière que la tension de référence (Ref) soit entraînée vers différentes valeurs de tension pour différents signaux d'erreur (Erreur, Dépassement).

5. Arrangement de capteur de courant selon la revendication 4, dans lequel deux signaux d'erreur différents (Erreur, Dépassement) sont prévus, moyennant quoi la tension de référence (Ref) est entraînée vers la terre (Gnd) pour le signal d'erreur (Erreur, Dépassement) et pour l'autre (Dépassement, Erreur), une tension d'alimentation (+) est entraînée.

6. Arrangement de capteur de courant selon la revendication 5, dans lequel les sorties à drain ouvert ou à collecteur ouvert des deux signaux d'erreur (Erreur, Dépassement) émettent des signaux qui sont opposés en phase l'un avec l'autre.

7. Arrangement de capteur de courant selon l'une des revendications précédentes, dans lequel un signal d'erreur (Erreur) signale une fonction d'erreur du module électronique (CS, A, DS) ou du module magnétique (PC, RC, AG, CW).

8. Arrangement de capteur de courant selon l'une des revendications précédentes, dans lequel un signal d'erreur (Dépassement) signale une opération de surcharge du module électronique (CS, A, DS) ou du module magnétique (PC, RC, AG, CW).

9. Arrangement de capteur de courant selon l'une des revendications précédentes, dans lequel le module magnétique (PC, RC, AG, CW) et le module électronique (CS, A, DS) forment un capteur de courant à compensation.

10. Arrangement de capteur de courant selon l'une des revendications 1 à 8, dans lequel le module magnétique (PC, RC, AG, CW) et le module électronique (CS, A, DS) forment un capteur de courant à imagerie directe.

## FIG 1

## FIG 2

$$I_{out} = (I_{test} + I_n)/N$$

$U_{out}$

$R_B$

## FIG 3

$$I_{out} = I_n/N$$

$U_{out}$

$R_B$

$$U_{test} = (I_{test} + I_{out}) * (R_I + R_B)$$

# FIG 4

EP 1 956 384 B1

# FIG 5

EP 1 956 384 B1

# FIG 6

EP 1 956 384 B1

# FIG 7

EP 1 956 384 B1

FIG 8

+5 V

$R_{pu}$

Error

Q2

Gnd

**IN DER BESCHREIBUNG AUFGEFÜHRTE DOKUMENTE**

**In der Beschreibung aufgeführte Patentdokumente**

- US 5654630 A

**In der Beschreibung aufgeführte Nicht-Patentliteratur**

- Sensor Signal Conditioning IC for Closed-Loop Magnetic Current Sensor. *Texas Instruments,* Oktober 2006